# EUROPEAN PATENT APPLICATION

(11) **EP 4 239 882 A1**
(43) Date of publication of application: **06.09.2023**
(21) Application number: 21905748.6
(22) Date of filing: 15.12.2021
(51) Int. Cl.: H03F 1/42

(54) **RADIOFREQUENCY POWER AMPLIFIER AND COUPLING CIRCUIT FOR INCREASING VIDEO BANDWIDTH**

(30) Priority: 16.12.2020 CN 202011488263
(71) Applicant: Huawei Technologies Co., Ltd., Shenzhen, Guangdong 518129 (CN)
(72) Inventor: SUN, Yiping, Shenzhen, Guangdong 518129 (CN); YANG, Maoqing, Shenzhen, Guangdong 518129 (CN); ZHANG, Lipeng, Shenzhen, Guangdong 518129 (CN)
(74) Representative: Goddar, Heinz J.
(86) International application number: PCT/CN2021/138317
(87) International publication number: WO 2022/127821

(57) **Abstract**

Embodiments of this application disclose a radio frequency power amplifier and a coupling circuit for increasing a video bandwidth, and may be applied to the field of radio frequency power amplifier technologies. The radio frequency power amplifier includes: a transistor, an internal matching circuit of the transistor, and a coupling circuit. A drain of the transistor is connected to an input end of the internal matching circuit. The coupling circuit is connected to the internal matching circuit. The transistor is configured to amplify a received radio frequency signal. The internal matching circuit is configured to: increase output impedance of the transistor in an operating frequency band, and output the amplified radio frequency signal. The coupling circuit is configured to reduce envelope impedance corresponding to an operating bandwidth of the transistor.

## Description

This application claims priority to Chinese Patent Application No. 202011488263.3, filed with the China National Intellectual Property Administration on December 16, 2020, and entitled "RADIO FREQUENCY POWER AMPLIFIER AND COUPLING CIRCUIT FOR INCREASING VIDEO BANDWIDTH", which is incorporated herein by reference in its entirety.

### TECHNICAL FIELD

This application relates to the field of radio frequency power amplifier technologies, and in particular, to a radio frequency power amplifier and a coupling circuit for increasing a video bandwidth.

### BACKGROUND

With the rapid development of communication systems, applications with a wide bandwidth or multicarrier modulated signals impose strict requirements on linearization of a radio frequency power amplifier. A video bandwidth (video bandwidth, VBW) that represents an operating bandwidth of a radio frequency power amplifier and a memory effect that affects power amplifier linearity become two important factors to evaluate performance of the radio frequency amplifier. The video bandwidth is critical for the operating bandwidth of the power amplifier. Specifically, the video bandwidth affects a correctable value of digital pre-distortion (digital pre-distortion, DPD) for the power amplifier. When an instantaneous signal bandwidth is excessively wide or close to a resonance frequency of a transistor that determines the video bandwidth, an effect of a DPD system on linear correction of the power amplifier severely deteriorates.

To improve radio frequency performance of the radio frequency power amplifier, generally, an internal matching circuit is input inside the power amplifier. The internal matching circuit is usually a low-pass LCL circuit, to implement high impedance of the radio frequency power amplifier in an operating frequency band, and improve conversion efficiency of the radio frequency power amplifier on a power supply. However, a design of the internal matching circuit increases envelope impedance of the power amplifier, reducing the video bandwidth and further affecting correction performance of the power amplifier. Therefore, how to increase a video bandwidth of a radio frequency power amplifier carrying an internal matching circuit and optimize performance of a video amplifier becomes an urgent problem to be resolved.

### SUMMARY

Embodiments of this application provide a radio frequency power amplifier and a coupling circuit for increasing a video bandwidth, to increase a video bandwidth of a radio frequency power amplifier while ensuring radio frequency performance of the radio frequency power amplifier, so as to improve amplification performance of the radio frequency power amplifier.

According to a first aspect, an embodiment of this application provides a radio frequency power amplifier. The radio frequency power amplifier includes a transistor, an internal matching circuit of the transistor, and a coupling circuit. The internal matching circuit is disposed at a drain of the transistor and serves as an output circuit of the transistor. The coupling circuit is connected to the internal matching circuit. When the radio frequency power amplifier amplifies a radio frequency signal, a gate of the transistor is configured to receive the radio frequency signal and amplify the radio frequency signal. The internal matching circuit serves as the output circuit to increase output impedance of the transistor. The coupling circuit is configured to reduce envelope impedance corresponding to an operating bandwidth of the transistor, to increase a video bandwidth of the entire radio frequency power amplifier.

In the foregoing radio frequency power amplifier, the internal matching circuit is added to increase the output impedance of the transistor, and an increase of the output impedance can enhance energy conversion efficiency, increase output power of the radio frequency signal, and improve radio frequency performance of the radio frequency power amplifier. In addition, the coupling circuit can reduce the envelope impedance corresponding to the operating bandwidth of the transistor. Because the coupling circuit is connected to the internal matching circuit, the coupling circuit can increase a video bandwidth of the transistor without affecting the radio frequency performance. This further optimizes amplification performance of the radio frequency power amplifier.

In an optional implementation, the internal matching circuit in the radio frequency power amplifier includes a low-pass LCL filter circuit including at least one inductor and a capacitor. The low-pass filter circuit can effectively increase the output impedance of the transistor, and improve the radio frequency performance of the radio frequency power amplifier.

In an optional implementation, in the internal matching circuit, the low-pass LCL filter circuit includes two inductors and one capacitor. One end of a first inductor is an input end of the internal matching circuit, and one end of a second inductor is an output end of the internal matching circuit. The two inductors and the capacitor are connected to a same point of a T shape, and the other end of the capacitor is grounded. Because the internal matching circuit is the output circuit of the transistor, one end of the first inductor is connected to the drain of the transistor, and one end of the second inductor serves as an output port of the radio frequency signal.

In an optional implementation, the coupling circuit needs to be connected to the internal matching circuit. Therefore, one end of the coupling circuit may be connected to a convergence point of the inductor and the capacitor in the internal matching circuit. In this way, because the other end of the capacitor is grounded, it is equivalent to connecting impedance to the capacitor in parallel. Because impedance corresponding to the capacitor in the internal matching circuit is low, even if impedance of the coupling circuit is low, there is small impact on the entire output impedance. In this way, an impedance value of the coupling circuit can be designed, to minimize the envelope impedance corresponding to the operating bandwidth, and better optimize the video bandwidth of the radio frequency power amplifier.

In an optional implementation, the coupling circuit may include a capacitor and an inductor. The coupling circuit may increase a resonance frequency of the radio frequency power amplifier by adjusting a capacitance value of the capacitor and/or inductance of the inductor, to reduce the envelope impedance corresponding to the operating bandwidth of the transistor.

In an optional implementation, the coupling circuit includes one inductor and one capacitor. The inductor is connected to the capacitor. The other end of the inductor is connected to a convergence point in the internal matching circuit, and the other end of the capacitor is grounded. In this way, the video bandwidth of the radio frequency power amplifier can be optimized by designing inductance of the inductor and/or capacitance of the capacitor.

In an optional implementation, the capacitor in the coupling circuit is a low-frequency decoupling capacitor.

In an optional implementation, the coupling circuit may alternatively include a resistor, a capacitor, and an inductor. Then the envelope impedance corresponding to the operating bandwidth of the transistor is reduced by adjusting a resistance value of the resistor, a capacitance value of the capacitor, and/or inductance of the inductor.

When the coupling circuit includes the resistor, capacitance adjustment may be performed in the coupling circuit at an nF level, that is, a minor change of capacitance of the capacitor can cause optimization of the video bandwidth, to improve optimization performance of the coupling circuit.

In an optional implementation, the coupling circuit may include one resistor, one inductor, and one capacitor. One end of the resistor is connected to one end of the inductor, one end of the inductor is connected to one end of the capacitor, and the resistor, the inductor, and the capacitor form a string structure. Then the resistor is connected to a convergence point in the internal matching circuit, and the other end of the capacitor is grounded.

In an optional implementation, in the foregoing coupling circuit that includes the resistor, the capacitor may be a low-frequency decoupling capacitor.

In an optional implementation, the radio frequency power amplifier further needs to include a power supply circuit. The power supply circuit is connected to the output end of the internal matching circuit, and is configured to provide a direct current to the radio frequency power amplifier.

A second aspect of embodiments of this application provides a coupling circuit for increasing a video bandwidth.

The coupling circuit is connected to an internal matching circuit of a transistor in a radio frequency power amplifier.

A drain of the transistor is connected to an input end of the internal matching circuit. The coupling circuit is connected to the internal matching circuit.

The transistor is configured to amplify a radio frequency signal received by the radio frequency power amplifier.

The internal matching circuit is configured to: increase output impedance of the radio frequency power amplifier in an operating frequency band, and output the amplified radio frequency signal.

The coupling circuit is configured to reduce envelope impedance corresponding to an operating bandwidth of the radio frequency power amplifier.

In an optional implementation, the coupling circuit includes a capacitor and an inductor. The coupling circuit is configured to reduce, by adjusting a capacitance value of the capacitor and/or inductance of the inductor, envelope impedance corresponding to an operating bandwidth of the transistor.

In an optional implementation, the coupling circuit includes a resistor, a capacitor, and an inductor. The coupling circuit is configured to reduce, by adjusting a resistance value of the resistor, a capacitance value of the capacitor, and/or inductance of the inductor, envelope impedance corresponding to an operating bandwidth of the transistor.

In an optional implementation, the capacitor in the coupling circuit is a low-frequency decoupling capacitor.

A third aspect of embodiments of this application further provides a radio frequency amplification system. The radio frequency amplification system includes a radio frequency power amplifier, and the radio frequency power amplifier may be the radio frequency power amplifier according to any embodiment of the first aspect.

According to the foregoing technical solutions, it can be learned that embodiments of this application have the following advantages:

In embodiments of this application, the internal matching circuit serves as the output circuit of the radio frequency power amplifier, and is connected to the drain of the transistor. This can increase the output impedance in the operating frequency band of the radio frequency power amplifier, and can improve the radio frequency performance of the radio frequency power amplifier. In addition, the internal matching circuit is connected to the coupling circuit. The coupling circuit can reduce, by adjusting a physical quantity of an internal component of the coupling circuit, the envelope impedance corresponding to the operating bandwidth of the radio frequency power amplifier, to increase the video bandwidth of the radio frequency power amplifier without affecting the radio frequency performance, and further improve the amplification performance of the radio frequency power amplifier.

### BRIEF DESCRIPTION OF DRAWINGS

FIG. 1 is a schematic diagram of a structure of a radio frequency power amplifier according to an embodiment of this application;
FIG. 2 is a curve diagram of an envelope impedance change of a radio frequency power amplifier according to an embodiment of this application;
FIG. 3 is a schematic diagram of a structure of another radio frequency power amplifier according to an embodiment of this application;
FIG. 4 is a schematic diagram of a structure of another radio frequency power amplifier according to an embodiment of this application;
FIG. 5 is a curve diagram of an envelope impedance change of another radio frequency power amplifier according to an embodiment of this application;
FIG. 6 is a schematic diagram of a structure of another radio frequency power amplifier according to an embodiment of this application; and
FIG. 7 is a curve diagram of an envelope impedance change of another radio frequency power amplifier according to an embodiment of this application.

### DESCRIPTION OF EMBODIMENTS

Embodiments of this application provide a radio frequency amplifier and a bias circuit for increasing a video bandwidth, to increase a video bandwidth of a radio frequency amplifier while ensuring radio frequency performance of the radio frequency amplifier, so as to improve amplification performance of the radio frequency amplifier.

The following describes technical solutions in this application in detail with reference to accompanying drawings in this application. Clearly, the described embodiments are only some rather than all of embodiments of this application.

In the specification, the claims, and the accompanying drawings of this application, the terms "first", "second", "third", "fourth", and the like (if existent) are intended to distinguish between similar objects but do not necessarily indicate a specific order or sequence. It should be understood that data used in such a way are interchangeable in appropriate circumstances so that the embodiments described herein can be implemented in other orders than the order illustrated or described herein. Moreover, the terms "include", "have" and any other variants mean to cover a non-exclusive inclusion, for example, a process, method, system, product, or device that includes a list of steps or units is not necessarily limited to those steps or units that are clearly listed, but may include other steps or units that are not clearly listed or that are inherent to such a process, method, product, or device.

A radio frequency power amplifier is an energy converter configured to perform power amplification on low-power baseband signals, and is one of key components of a wireless communication network system. Generally, quality of the radio frequency power amplifier may be measured by using indicators such as output power, efficiency, and an operating bandwidth. However, these indicators restrict each other when they are increased. For example, a wider operating bandwidth is obtained at the expense of specific efficiency and power, and vice versa. Therefore, how to improve amplification performance of the radio frequency power amplifier is a problem worthy of study.

Generally, the output power and the efficiency are used to evaluate radio frequency performance of the radio frequency power amplifier, and are related to output impedance corresponding to an operating frequency band of the radio frequency power amplifier. In the operating frequency band, higher output impedance of the radio frequency power amplifier indicates higher power conversion efficiency and better radio frequency performance. Therefore, an internal matching circuit may be designed for a transistor of the radio frequency power amplifier, to improve the output impedance.

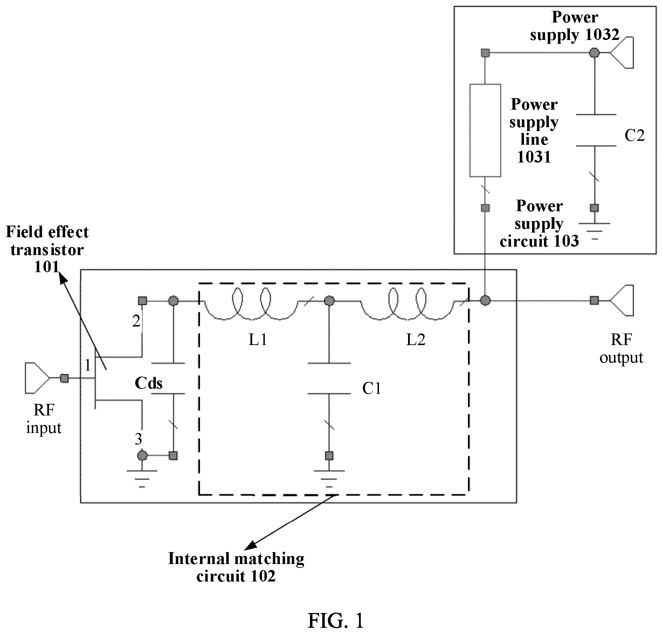

FIG. 1 is a schematic diagram of a structure of a radio frequency power amplifier according to an embodiment of this application. As shown in FIG. 1, the radio frequency power amplifier includes a field effect transistor (transistor) 101, an internal matching circuit 102, and a power supply circuit 103.

A drain of the field effect transistor 101 is connected to an input end of an internal matching circuit, and the power supply circuit 103 is connected to an output end of the internal matching circuit. A capacitor Cds is a parasitic capacitor between a source and a drain of the field effect transistor 101. The internal matching circuit 102 is a low-pass LCL filter circuit, and includes an inductor L1, an inductor L2, and a capacitor C1 that are connected in a "T" shape. One end of the capacitor C1 is connected to one end of the inductor L1 and one end of the inductor L2, and the other end of the capacitor C1 is grounded. The other end of the inductor L1 is an input end of the internal matching circuit 102, and is connected to the drain of the field effect transistor 101. The other end of the inductor L2 is an output end of the radio frequency power amplifier. The power supply circuit 103 includes a power supply line 1031, a power supply 1032, and a capacitor C2. The power supply 1032 is connected to the output end of the internal matching circuit 102 by using the power supply line 1031. One end of the capacitor C2 is connected to an output end of the power supply 1032, and one end of the capacitor C2 is grounded.

The internal matching circuit 101 is configured to improve radio frequency performance of the radio frequency power amplifier. When the radio frequency power amplifier operates in an operating frequency band, the capacitor and the inductors in the internal matching circuit can increase output impedance of the radio frequency working amplifier, to improve efficiency of the radio frequency working amplifier. However, the internal matching circuit also increases envelope impedance corresponding to an operating bandwidth of the radio frequency working amplifier, reducing a video bandwidth corresponding to the radio frequency power amplifier.

The power supply circuit 103 provides a direct current power supply to a power transistor of the radio frequency power amplifier, and the power supply line 1031 included in the power supply circuit 103 also corresponds to inductance L3. However, a capacitance value of the capacitor C2 in the power supply circuit 103 is large. For example, when an operating frequency of the radio frequency power amplifier is greater than 100 MHz, it may be considered that the radio frequency power amplifier is in a short-circuited state, and a main function of the capacitor C2 is low-pass filtering, to avoid a radio frequency signal loss caused by radiation of a radio frequency signal from a power supply end. In this way, in the entire radio frequency power amplifier, the envelope impedance corresponding to the operating bandwidth of the radio frequency power amplifier can be reduced by reducing the inductance of the power supply line 1031 in the power supply circuit 103. However, a reduction in the inductance of the power supply line 1031 causes a reduction in output impedance in the operating frequency band, and affects the radio frequency performance of the radio frequency power amplifier. Therefore, high inductance of the power supply line is generally required, resulting in an extremely limited optimization effect of the video bandwidth.

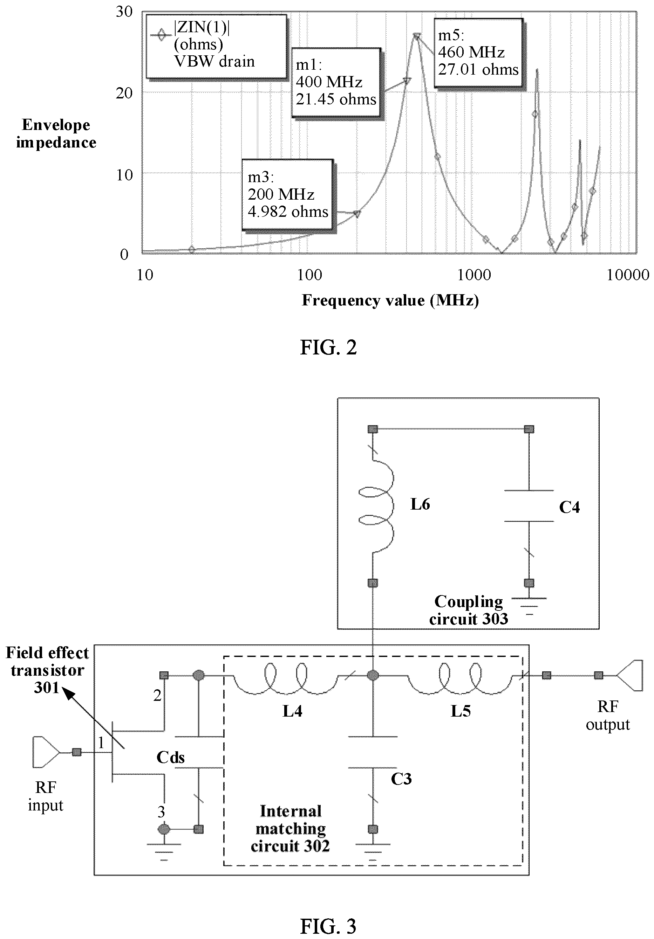

FIG. 2 is a curve diagram of an envelope impedance change of a radio frequency power amplifier according to an embodiment of this application. As shown in FIG. 2, a horizontal coordinate of the curve diagram indicates a frequency value, and a vertical coordinate indicates an impedance value of envelope impedance. A horizontal coordinate corresponding to an impedance peak m5 is a resonance frequency corresponding to the radio frequency power amplifier. Assuming that a radio frequency signal amplified by the radio frequency power amplifier is of 3.4 GHz to 3.8 GHz, an operating bandwidth corresponding to the radio frequency power amplifier is 400 MHz. It can be learned from the diagram that if the impedance peak is shifted to the right, that is, a resonance frequency corresponding to the impedance peak becomes larger, an impedance value of envelope impedance corresponding to a fixed frequency of 200 MHz/400 MHz decreases, a video bandwidth increases, and a linearity result of DPD correction is better.

Based on the foregoing content, an embodiment of this application provides a new radio frequency power amplifier. The radio frequency power amplifier includes an internal matching circuit for improving radio frequency performance, and further includes a coupling circuit for optimizing a video bandwidth. On a basis that a radio frequency function of the radio frequency power amplifier is not affected, the video bandwidth of the radio frequency power amplifier is increased, and amplification performance of the radio frequency power amplifier is improved.

FIG. 3 is a schematic diagram of a structure of another radio frequency power amplifier according to an embodiment of this application. As shown in FIG. 3, the radio frequency power amplifier includes a field effect transistor (transistor) 301, an internal matching circuit 302, and a coupling circuit 303.

A drain of the field effect transistor 301 is connected to an input end of the internal matching circuit, and a capacitor Cds is a parasitic capacitor between a source and the drain of the field effect transistor 301. The internal matching circuit 302 is a low-pass LCL filter circuit, and includes an inductor L4, an inductor L5, and a capacitor C3 that are connected in a "T" shape. A connection point is a point A. One end of the capacitor C3 intersects with one end of the inductor L4 and one end of the inductor L5 at the point A, and the other end of the capacitor C3 is grounded. The other end of the inductor L4 is an input end of the internal matching circuit 302, and is connected to the drain of the field effect transistor 301. The other end of the inductor L5 is an output end of the radio frequency power amplifier. The coupling circuit 303 includes an inductor L6 and a capacitor C4. One end of the inductor L6 is connected to the point A, the other end of the inductor L6 is connected to one end of the capacitor C4, and the other end of the capacitor C4 is grounded.

The field effect transistor (field effect transistor, FET) is packaged in a semiconductor chip and may be made of semiconductor materials such as gallium nitride GaN, a laterally-diffused metal-oxide semiconductor LDMOS, and gallium arsenide GaAs. Cds is the parasitic capacitor between the source and the drain of the FET. The internal matching circuit 302 is configured to improve input impedance and radio frequency performance of the radio frequency power amplifier. Both the inductors L4 and L5 may be implemented by using a bond wire bond wire, and the capacitor C3 may be implemented by using a single layer capacitor (single layer capacitor, SLC) or metal-oxide-semiconductor capacitor (metal-oxide-semiconductor capacitor, moscap). The coupling circuit 303 is configured to increase a video bandwidth of the radio frequency power amplifier. The inductor L6 may also be implemented by using a bond wire bond wire, and the capacitor C4 may be a low-frequency decoupling capacitor, and is connected to the capacitor C3 in the internal matching circuit 302 by using the inductor L6.

The following describes in detail a working principle of the foregoing radio frequency power amplifier. The internal matching circuit 302 is configured to improve the radio frequency performance of the radio frequency power amplifier. When the radio frequency power amplifier operates in an operating frequency band, the capacitor and the inductors in the internal matching circuit can increase output impedance of the radio frequency working amplifier, to improve efficiency of the radio frequency working amplifier. In this case, impedance corresponding to the capacitor C3 is less than the output impedance. Therefore, connecting the coupling circuit 303 at the point A is equivalent to connecting impedance to the capacitor C3 in parallel. In this way, even if impedance of the coupling circuit 303 is designed to be very low, impact of the coupling circuit 303 on the output impedance is very small. Therefore, in the operating frequency band, addition of the coupling circuit 303 has small impact on the output impedance of the entire radio frequency power amplifier, to ensure the radio frequency performance of the radio frequency power amplifier.

The coupling circuit 303 is configured to: increase the video bandwidth of the radio frequency power amplifier, and reduce, by adjusting inductance of the inductor L6 and capacitance of the capacitor C4, envelope impedance corresponding to an operating bandwidth of the radio frequency power amplifier, to increase the video bandwidth. In addition, addition of the inductor L6 and the capacitor C4 may cause an increase in a resonance frequency of the radio frequency power amplifier. In this way, an envelope impedance change curve may be shifted right with a horizontal coordinate (a frequency value), so that at a fixed frequency of 200 MHz/400 MHz, an impedance value of envelope impedance corresponding to the fixed frequency decreases, the video bandwidth increases, and a linearity result of DPD correction is better.

It may be understood that, because the coupling circuit 303 has small impact on the output impedance of the radio frequency power amplifier, impedance corresponding to the coupling circuit 303 may be designed to be as low as possible. In this way, an optimization degree of the coupling circuit 303 for the video bandwidth is higher, and amplification performance of the radio frequency power amplifier can be improved.

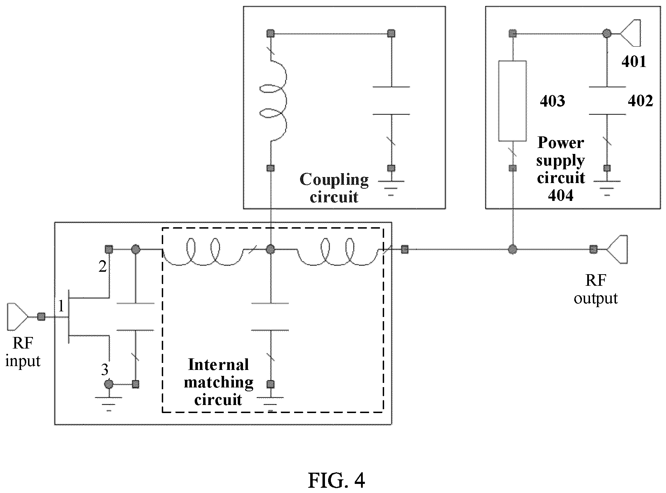

The radio frequency power amplifier may further include a power supply circuit. As shown in FIG. 4, the power supply circuit 404 is configured to supply power to a power transistor, and includes a power supply 401, a capacitor 402, and a power supply line 403. The power supply is configured to provide a direct current to the power transistor, and a capacitance value of the capacitor 402 is large. For example, when an operating frequency of the radio frequency power amplifier is greater than 100 MHz, it may be considered that the radio frequency power amplifier is in a short-circuited state, and a main function of the capacitor 402 is low-pass filtering, to avoid a radio frequency signal loss caused by radiation of a radio frequency signal from a power supply end. The power supply line 403 corresponds to inductance. It may be understood that the inductance of the power supply line 103 may be reduced, to reduce the envelope impedance corresponding to the operating bandwidth of the radio frequency power amplifier, and increase the video bandwidth of the radio frequency power amplifier. However, in order not to affect the radio frequency performance of the radio frequency power amplifier, the inductance of the power supply line is required not to be excessively low.

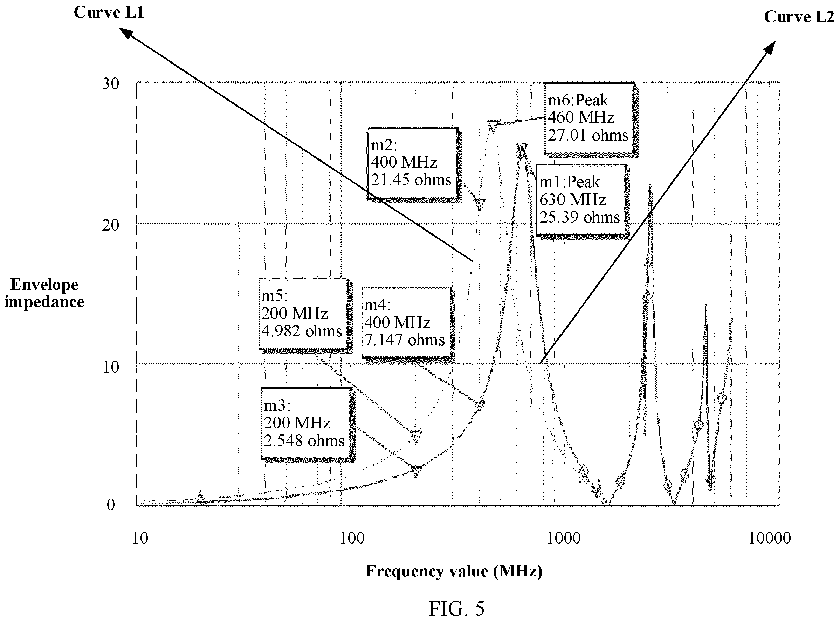

FIG. 5 is a curve diagram of an envelope impedance change corresponding to the radio frequency power amplifier shown in FIG. 4. As shown in the diagram, a horizontal coordinate still indicates a frequency value, and a vertical coordinate indicates an envelope impedance value. A curve L1 is a curve diagram of an envelope impedance change of the radio frequency power amplifier when no coupling circuit is added, and a curve L2 is a curve diagram of an envelope impedance change of the radio frequency power amplifier when a coupling circuit is added. It can be learned from the curve L1 and the curve L2 that, after the coupling circuit is added, a resonance frequency of the radio frequency power amplifier becomes higher. Therefore, on a left side of the resonance frequency, an impedance value of envelope impedance corresponding to a fixed frequency decreases. For example, for 200 MHz, an original envelope impedance value is 5 ohms, and an optimized envelope impedance value decreases to 4 ohms. For another example, for 400 MHz, an original envelope impedance value is 21 ohms, and an optimized envelope impedance value decreases to 7 ohms. In this way, envelope impedance corresponding to the operating bandwidth is greatly reduced, and the video bandwidth of the radio frequency power amplifier is increased.

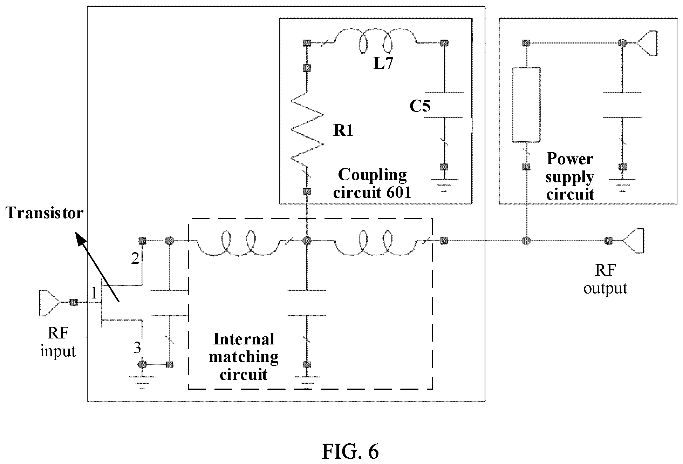

FIG. 6 is a schematic diagram of a structure of another radio frequency power amplifier according to an embodiment of this application. A coupling circuit may alternatively include a resistor, a capacitor, and an inductor. As shown in FIG. 6, a coupling circuit 601 includes a resistor R1, an inductor L7, and a capacitor C5. The resistor R1 is connected to a capacitor in an internal matching circuit.

The resistor R1 may be manufactured by a thin film process, the inductor L7 may be implemented by using a bond wire, and C5 is a low-frequency decoupling capacitor. It may be understood that a structure of another part of the radio frequency power amplifier is similar to structures in the embodiments shown in FIG. 3 and FIG. 4, and details are not described herein again.

When the coupling circuit 601 includes the resistor R1, the capacitor C5 in the coupling circuit may be reduced at an nF level. In addition, the resistor in the coupling circuit 601 and the capacitor in the internal matching circuit may be implemented in a same electronic component. In this way, a volume of the circuit can be reduced.

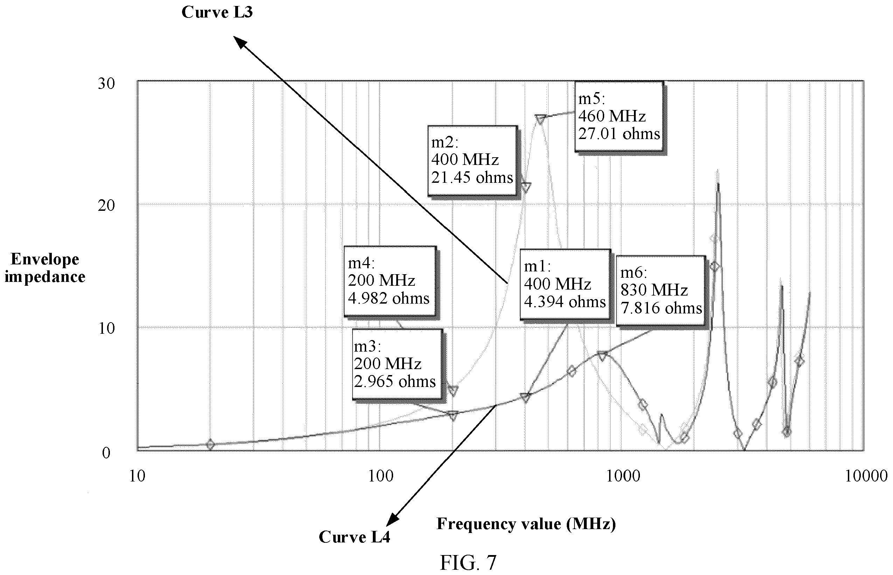

FIG. 7 is a curve diagram of an envelope impedance change corresponding to the radio frequency power amplifier shown in FIG. 6. As shown in the figure, a horizontal coordinate still indicates a frequency value, and a vertical coordinate indicates an envelope impedance value. A curve L3 is a curve diagram of an envelope impedance change of the radio frequency power amplifier when no coupling circuit is added, and a curve L4 is a curve diagram of an envelope impedance change of the radio frequency power amplifier when a coupling circuit is added. It can be learned from the curve L3 and the curve L4 that, after the coupling circuit is added, a resonance frequency of the radio frequency power amplifier becomes higher. Therefore, an impedance value of envelope impedance corresponding to a fixed frequency decreases. For example, for 200 MHz, an original envelope impedance value is 5 ohms, and an optimized envelope impedance value decreases to 3 ohms. For another example, for 400 MHz, an original envelope impedance value is 21 ohms, and an optimized envelope impedance value decreases to 7 ohms. In this way, envelope impedance corresponding to an operating bandwidth is greatly reduced, and a video bandwidth of the radio frequency power amplifier is increased.

In the foregoing embodiments, the internal matching circuit serves as the output circuit of the radio frequency power amplifier, and is connected to the drain of the transistor. This can increase the output impedance in the operating frequency band of the radio frequency power amplifier, and can improve the radio frequency performance of the radio frequency power amplifier. In addition, the internal matching circuit is connected to the coupling circuit. The coupling circuit can reduce, by adjusting a physical quantity of an internal component of the coupling circuit, the envelope impedance corresponding to the operating bandwidth of the radio frequency power amplifier, to increase the video bandwidth of the radio frequency power amplifier without affecting the radio frequency performance, and further improve the amplification performance of the radio frequency power amplifier.

An embodiment further provides a coupling circuit for increasing a video bandwidth. The coupling circuit is connected to an internal matching circuit of a transistor in a radio frequency power amplifier.

A drain of the transistor is connected to an input end of the internal matching circuit. The coupling circuit is connected to the internal matching circuit.

The transistor is configured to amplify a radio frequency signal received by the radio frequency power amplifier.

The internal matching circuit is configured to: increase output impedance of the radio frequency power amplifier in an operating frequency band, and output the amplified radio frequency signal.

The coupling circuit is configured to reduce envelope impedance corresponding to an operating bandwidth of the radio frequency power amplifier.

In an optional implementation, the coupling circuit includes a capacitor and an inductor. The coupling circuit is configured to reduce, by adjusting a capacitance value of the capacitor and/or inductance of the inductor, envelope impedance corresponding to an operating bandwidth of the transistor.

In an optional implementation, the coupling circuit includes a resistor, a capacitor, and an inductor. The coupling circuit is configured to reduce, by adjusting a resistance value of the resistor, a capacitance value of the capacitor, and/or inductance of the inductor, envelope impedance corresponding to an operating bandwidth of the transistor.

In an optional implementation, the capacitor in the coupling circuit is a low-frequency decoupling capacitor.

An embodiment further provides a radio frequency amplification system. The radio frequency amplification system includes a radio frequency power amplifier. For the radio frequency power amplifier, refer to any radio frequency power amplifier in the foregoing embodiments. Details are not described again.

It should be noted that, the foregoing embodiments are only used to describe the technical solutions of this application, but not to limit the technical solutions. Although this application is described in detail with reference to the foregoing embodiments, a person of ordinary skill in the art should understand that: the technical solutions described in the foregoing embodiments may still be modified, or some technical features thereof may be equivalently replaced. However, these modifications or replacements do not make the essence of the corresponding technical solutions depart from the spirit and scope of the technical solutions in embodiments of this application.

## Claims

1. A radio frequency power amplifier, wherein the radio frequency power amplifier comprises: a transistor, an internal matching circuit of the transistor, and a coupling circuit;
a drain of the transistor is connected to an input end of the internal matching circuit; the coupling circuit is connected to the internal matching circuit;
the transistor is configured to amplify a received radio frequency signal;
the internal matching circuit is configured to: increase output impedance of the transistor in an operating frequency band, and output the amplified radio frequency signal; and
the coupling circuit is configured to reduce envelope impedance corresponding to an operating bandwidth of the transistor.

2. The radio frequency power amplifier according to claim 1, wherein the internal matching circuit of the transistor comprises a low-pass LCL filter circuit, and the low-pass LCL filter circuit comprises a capacitor and an inductor.

3. The radio frequency power amplifier according to claim 2, wherein the low-pass LCL filter circuit comprises a first inductor, a second inductor, and a first capacitor;
a first end of the first inductor is an input end of the internal matching circuit, and is connected to the drain of the transistor; a second end of the first inductor is connected to a first end of the second inductor, and a second end of the second inductor is an output end of the internal matching circuit; and
a first end of the first capacitor is connected to the second end of the first inductor, and a second end of the first capacitor is grounded.

4. The radio frequency power amplifier according to claim 3, wherein one end of the coupling circuit is connected to the second end of the first inductor.

5. The radio frequency power amplifier according to claim 4, wherein the coupling circuit comprises a capacitor and an inductor; and the coupling circuit is configured to reduce, by adjusting a capacitance value of the capacitor and/or inductance of the inductor, the envelope impedance corresponding to the operating bandwidth of the transistor.

6. The radio frequency power amplifier according to claim 5, wherein the coupling circuit comprises a third inductor and a second capacitor;
a first end of the third inductor is connected to the second end of the first inductor; a second end of the third inductor is connected to a first end of the second capacitor; and a second end of the second capacitor is grounded.

7. The radio frequency power amplifier according to claim 6, wherein the second capacitor is a low-frequency decoupling capacitor.

8. The radio frequency power amplifier according to claim 4, wherein the coupling circuit comprises a resistor, a capacitor, and an inductor; and the coupling circuit is configured to reduce, by adjusting a resistance value of the resistor, a capacitance value of the capacitor, and/or inductance of the inductor, the envelope impedance corresponding to the operating bandwidth of the transistor.

9. The radio frequency power amplifier according to claim 8, wherein the coupling circuit comprises a first resistor, a fourth inductor, and a third capacitor;
a first end of the first resistor is connected to the second end of the first inductor, and a second end of the first resistor is connected to a first end of the fourth inductor;
a second end of the fourth inductor is connected to a first end of the third capacitor; and a second end of the third capacitor is grounded.

10. The radio frequency power amplifier according to claim 9, wherein the third capacitor is a low-frequency decoupling capacitor.

11. The radio frequency power amplifier according to any one of claims 1 to 10, wherein the radio frequency power amplifier further comprises a power supply circuit, and the power supply circuit is connected to the output end of the internal matching circuit; and
the power supply circuit is configured to supply power to the radio frequency power amplifier.

12. A coupling circuit for increasing a video bandwidth, wherein the coupling circuit is connected to an internal matching circuit of a transistor in a radio frequency power amplifier;
a drain of the transistor is connected to an input end of the internal matching circuit; the coupling circuit is connected to the internal matching circuit;
the transistor is configured to amplify a radio frequency signal received by the radio frequency power amplifier;
the internal matching circuit is configured to: increase output impedance of the radio frequency power amplifier in an operating frequency band, and output the amplified radio frequency signal; and
the coupling circuit is configured to reduce envelope impedance corresponding to an operating bandwidth of the radio frequency power amplifier.

13. The coupling circuit according to claim 12, wherein the coupling circuit comprises a capacitor and an inductor; and the coupling circuit is configured to reduce, by adjusting a capacitance value of the capacitor and/or inductance of the inductor, envelope impedance corresponding to an operating bandwidth of the transistor.

14. The coupling circuit according to claim 12, wherein the coupling circuit comprises a resistor, a capacitor, and an inductor; and the coupling circuit is configured to reduce, by adjusting a resistance value of the resistor, a capacitance value of the capacitor, and/or inductance of the inductor, the envelope impedance corresponding to the operating bandwidth of the transistor.

15. The coupling circuit according to claim 13 or 14, wherein the capacitor in the coupling circuit is a low-frequency decoupling capacitor.

16. A radio frequency amplification system, wherein the radio frequency amplification system comprises a radio frequency power amplifier, and the radio frequency power amplifier is the radio frequency power amplifier according to any one of claims 1 to 11.
